# EUROPEAN PATENT SPECIFICATION

(11) **EP 4 518 599 B1**
(45) Date of publication and mention of the grant of the patent: **31.12.2025**
(21) Application number: 23306435.1
(22) Date of filing: 30.08.2023
(51) Int. Cl.: H05K 7/20

(54) **LEAK DETECTION SYSTEM FOR IMMERSIVE-COOLED RACK-MOUNTED ASSEMBLIES**
LECKDETEKTIONSSYSTEM FÜR TAUCHGEKÜHLTE GESTELLMONTIERTE ANORDNUNGEN
SYSTÈME DE DÉTECTION DE FUITE POUR ENSEMBLES MONTÉS SUR BÂTI REFROIDIS PAR IMMERSION

(43) Date of publication of application: 05.03.2025
(73) Proprietor: OVH, 59100 Roubaix (FR)
(72) Inventor: THIBAUT, Christophe Maurice, 59139 Noyelles les seclin (FR); KLABA, Miroslaw Pierre, 59100 Roubaix (FR); PROUST, Laurent, 59112 Annoeulin (FR)
(74) Representative: BCF Global

(56) References cited:
- WO-A1-2022/208403
- CN-U- 203 981 246
- US-B1- 10 152 096

## Description

### FIELD OF TECHNOLOGY

The present technology relates to a leak detection system for datacenter rack-mounted processing assemblies. In particular, the present technology relates to a leak detection system that detects and indicate presence of a leaking fluid in an immersive-cooled rack-mounted assembly.

### BACKGROUND

Electronic equipment, for example processing servers, memory banks, computer disks, and the like, are conventionally arranged in electronic equipment racks. Large datacenters as well as other large computing facilities may contain thousands of racks supporting thousands or even tens of thousands of processing servers. These electronic equipment racks typically consume large amounts of electrical power and generate significant amounts of heat.

As such, cooling measures are employed to control the heat generated by such electronic equipment. One such cooling measure, direct liquid cooling blocks, in particular water cooling, has been used as an addition or replacement to traditional forced-air cooling. Cold plates, for example water blocks having internal channels for channelized water circulation, may be mounted on heat-generating components, such as processors, to displace heat from the processors toward heat exchangers. Additionally, immersion cooling (sometimes called immersive cooling) has also been employed. That is, electronic components are inserted in a container that is fully or partially filled with a non-conducting cooling liquid, for example an oil-based dielectric cooling liquid. Efficient thermal contact is obtained between the electronic components and the dielectric cooling liquid. Immersion cooling systems commonly take the form of large tanks in which the electronic devices are submerged. In even other cooling measures, hybrid cooling systems that involve both water cooling and immersion cooling techniques have been employed to increase the cooling effectiveness of heat generating electronic components.

However, such liquid cooling systems may be prone to certain malfunctions, such as, for example, water block failures, dielectric cooling liquid leakages, etc. As such, leak detection systems for liquid-cooled electronic devices are currently being designed.

Existing cooling monitoring systems for liquid-cooled electronic devices typically require numerous sensors and controllers with corresponding wiring that limits the utilization of racks and adds to operating costs. Therefore, there is an interest in developing alternative low cost, independently-addressable leak detection systems without complicated sensors and controllers that are capable of providing sufficient indication to an operator of the datacenter in the event of leak occurrences.

WO2022/208403, CN203981246 and US10152096 disclose systems according to prior art.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

The invention is defined by the independent claims. Preferred embodiments are defined by the dependent claims.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned objects and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects, and advantages of implementations of the present technology will become apparent from the following description, the accompanying drawings and the appended claims.

### BRIEF DESCRIPTION OF THE DRAWINGS

These and other features, aspects and advantages of the present technology will become better understood with regard to the following description, appended claims and accompanying drawings where:
Figure 1 depicts a perspective view of a datacenter rack system housing numerous rack-mounted assemblies with a leak detection system, in accordance with the implementations of the present disclosure;
Figure 2 depicts a perspective view of a rack-mounted assembly with a leak detection system, in accordance with the implementations of the present disclosure;
Figure 3A depicts a schematic side view of an exemplary leak detection system of rack-mounted assemblies in a first configuration, in accordance with the implementations of the present disclosure;
Figure 3B depicts a schematic side view of the exemplary leak detection system of Figure 3A in a second configuration, in accordance with the implementations of the present disclosure; and
Figure 4 depicts a perspective view of the exemplary leak detection system of Figure 3A in accordance with the implementations of the present disclosure.

It should also be noted that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

With these fundamentals in place, we will now consider some non-limiting examples to illustrate various implementations of aspects of the present disclosure.

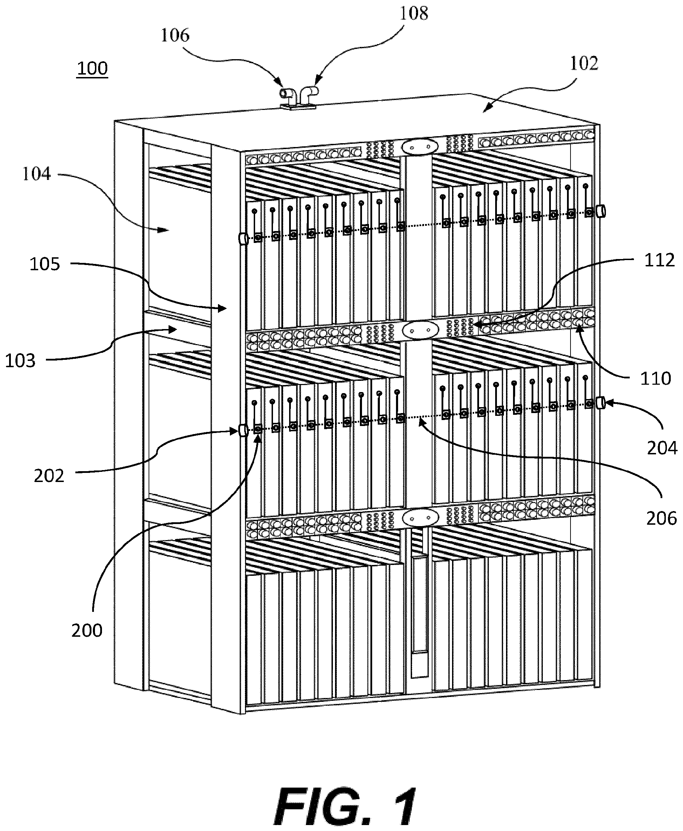

Figure 1 shows a perspective view of a rack system 100 for housing numerous rack-mounted assemblies 104 with corresponding leak detection systems 200, in accordance with the implementations of the present disclosure. As shown, the rack system 100 may include a rack frame 102, rack-mounted assemblies 104, a liquid cooling inlet conduit 106 and a liquid cooling outlet conduit 108. The rack-mounted assemblies 104 may be oriented vertically with respect to the rack frame 102, resembling books on a library shelf. This arrangement may provide for mounting a large number of such rack-mounted assemblies 104 in the rack frame 102, relative to conventional arrangements, particularly with respect to conventional arrangements of immersion-cooled rack-mounted assemblies.

Additionally, as shown, the rack system 100 may further comprise a power distribution unit (PDU) 110 and liquid coolant inlet/outlet connectors 112. It is to be noted that the rack system 100 may include other components such as heat exchangers, cables, pumps or the like, however, such components have been omitted from Figure 1 for clarity of understanding. As shown in Figure 1, the rack frame 102 may include rack shelves 103 to accommodate one or more rack-mounted assemblies 104. As noted above, the one or more rack-mounted assemblies 104 may be arranged vertically with respect to the rack shelves 103. In some implementations, guide members (not shown) may be used on the rack shelves 103 to guide the rack-mounted assemblies 104 into position during racking and de-racking, and to provide proper spacing between the rack-mounted assemblies 104 for racking and de-racking.

As further shown in Figure 1, the rack frame 102 may also include rack posts 105 to support the rack shelves 103. Mounted on the rack posts 105 are optical transmitters 202 and optical receivers 204 of which only two of each are shown for clarity. As described more fully below, the optical transmitters 202 and optical receivers 204 are arranged to cooperate with the leak detection systems 200 to indicate a location of overheated rack-mounted assemblies 104.

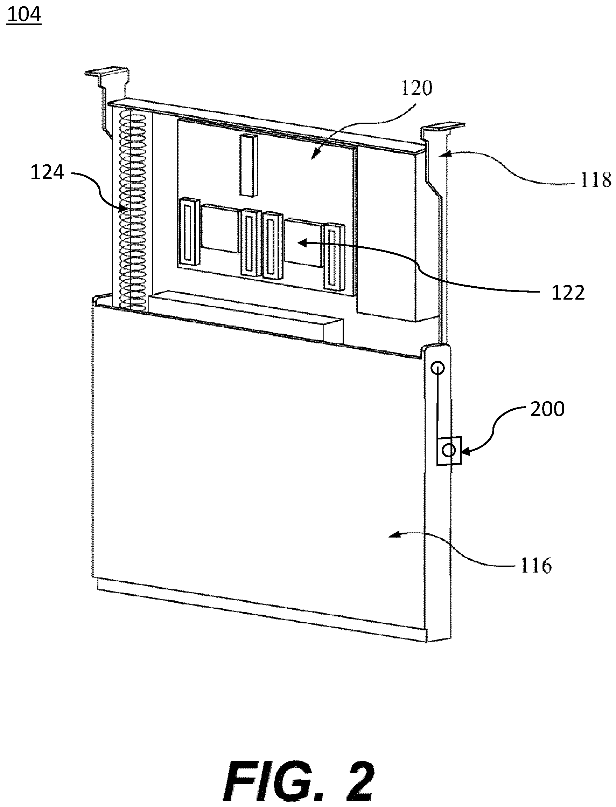

Figure 2 shows a perspective view of a rack-mounted assembly 104 with a leak detection system 200, in accordance with the implementations of the present disclosure. As shown, the rack-mounted assembly 104 includes a detachable frame, or "board" 118 of the electronic device 120, and an immersion case 116 wherein the leak detection system 200 is mounted on. The board 118 holds heat-generating electronic components 122 of the electronic device 120 and may be immersed in the immersion cooling liquid within the immersion case 116. Examples of heat-generating components include, but are not limited to, central processing units (CPUs), graphics processing units (GPUs), neural processing units (NPUs), tensor processing units (TPUs), power supply circuitry, and application specific integrated circuits (ASICs), including, for example, ASICs configured for high-speed cryptocurrency mining.

Although, the immersion case 116, board 118, and electronic components 122 are shown as separate parts, it will be understood by one of ordinary skill in the art that, in some implementations, two or more of these components could be combined. For example, the electronic components 122 could be fixed directly on the board 118 and/or the immersion case 116.

It is contemplated that the electronic devices 120 may generate a significant amount of heat. Consequently, the rack system 100 may use a cooling system to cool down the electronic devices 120 to prevent the electronic devices 120 from being damaged. In this implementation, the cooling system of the rack-mounted assembly 104 is a hybrid cooling system including an immersion cooling system and a channelized cooling system.

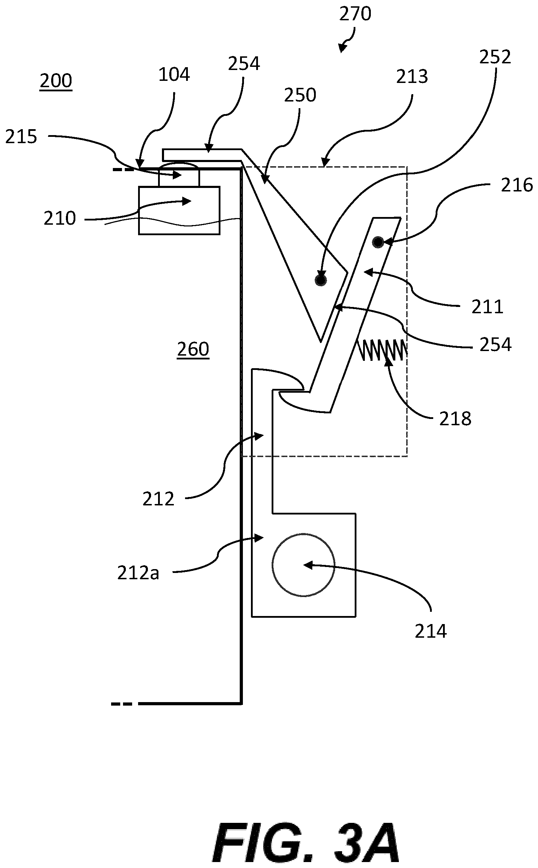

As used herein, an immersion cooling system is a cooling system in which the electronic device is in direct contact with a non-conductive (dielectric) cooling liquid, which either flows over at least portions of the electronic device, or in which at least portions of the electronic device are submerged. For example, in the rack-mounted assembly 104, the immersion case 116 may contain an immersive cooling liquid 260 (see Figure 3A). Further, the board 118 including the electronic components 122 may be submerged at least in part in the immersion cooling case 116. In some implementations, the dielectric immersion cooling liquid and the board 118 may be inserted into the immersion case 116 via an opening 122 at the top of the immersion case 116. In some implementations, the opening 122 may remain at least partially open during operation of the electronic device 120, providing a non-sealed configuration for the immersion case 116. Such non-sealed configurations may be easier to manufacture and maintain than sealed configurations, but may be inappropriate for, *e.g*., two-phase systems, in which the immersion cooling liquid may boil during operation of the electronic device 120.

As used herein, a channelized cooling system is a cooling system in which heat-generating components of the electronic device 120 (i.e. the electronic components 122) or the dielectric cooling liquid are cooled using liquid cooling units, which may also be called "cold plates" or "water blocks" (although a liquid circulating through the "water blocks" may be any of a wide variety of known thermal transfer liquids, rather than water), a convection-inducing structure, such as a serpentine convection coil 124 in which a flow of cooling liquid (e.g. water) is maintained may be used to cool the dielectric cooling liquid via natural convection, or any other suitable device.

In this implementation, the immersion case 116 may also include structures or devices for cooling the dielectric cooling liquid. For example, a convection-inducing structure, such as a serpentine convection coil 124 in which a flow of channelized cooling liquid (e.g. water) is maintained may be used to cool the immersion cooling liquid via natural convection. Alternatively or additionally, a pump (not shown) may be used to circulate the immersion cooling liquid either within the immersion case 116 or through an external cooling system (not shown). In some implementations, a two-phase system in which immersion cooling liquid in a gaseous phase is cooled by condensation may be used. Generally, any technology or combination for cooling the immersion cooling liquid may be used without departing from the principles disclosed herein. The serpentine convection coil 124 may be omitted or replaced with other convection-inducing structures or devices for circulating the immersion cooling liquid in some implementations.

As described more fully below, in the event that the hybrid cooling system of the rack-mounted assembly 104 malfunctions, such as, for example, when a leak of a channelized cooling liquid (e.g. water flowing in the serpentine coil 124 leaks in the immersion case 116) occurs, the leak detection system 200 is able to provide visual indication that a leak is occurring to an operator such that action may be taken to protect the electronic device 120 from failure due to overheating or short-circuits occurring due to leaking fluid.

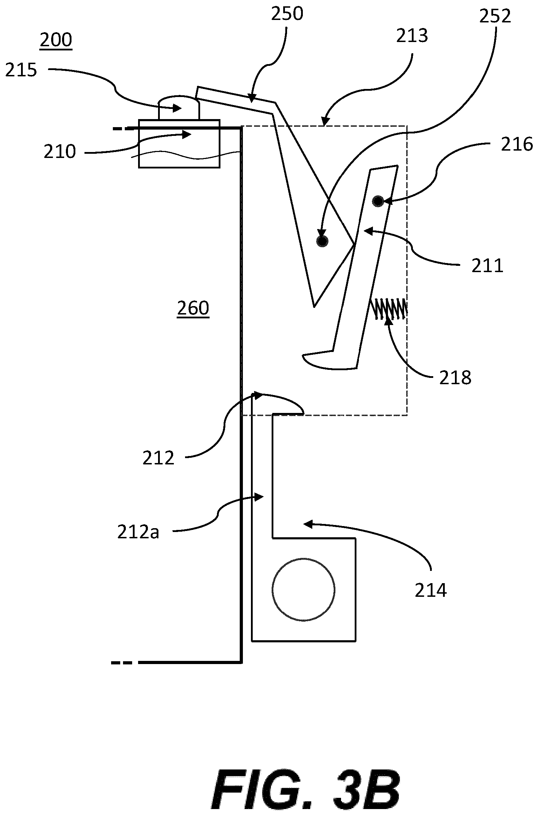

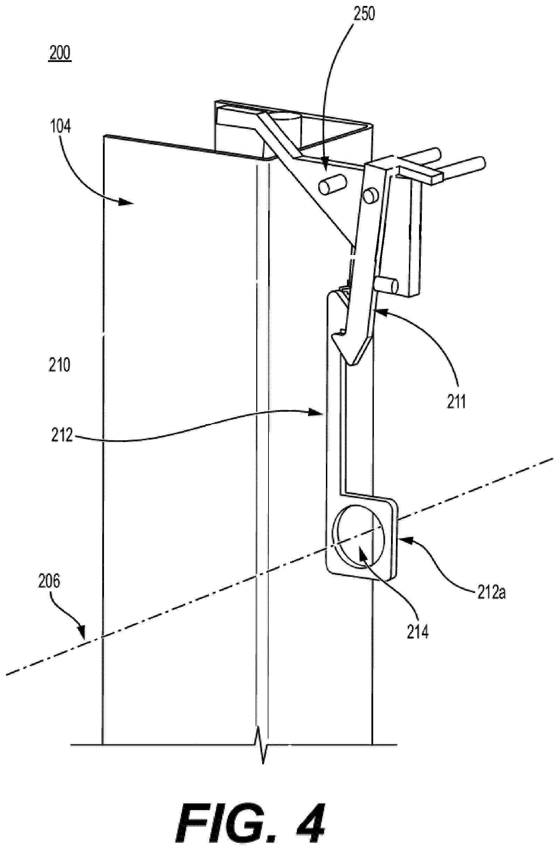

Figures 3A shows an exemplary leak detection system 200 for rack-mounted assemblies 104 under normal operations (i.e. "operating" configuration), in accordance with the implementations of the present disclosure. As shown on Figures 3a and 4, the leak detection system 200 includes a floating unit 210 and a first, a second and a third lever elements 250, 211, 212 that are mechanically coupled together for each electronic device 120. The first, a second and a third lever elements 250, 211, 212 form a lever assembly 270. As will be described in greater details herein after, upon presence of a leaking fluid in the immersion case 116, the floating unit 210 rises and mechanically interacts with the lever assembly 270 to switch the leak detection system 200 from the "operating" configuration to a "failure" configuration, as shown in Figure 3B, indicative of abnormal operation conditions (i.e. that a leak is occurring or has occurred).

Referring back to Figure 3A, the floating unit 210 of the leak detection system 200 is placed in the dielectric immersion cooling in the immersion case 116 of a corresponding rack-mounted assembly 104. The first lever element 250 is attached to a protective housing 213 of the leak detection system 200, such as, for example, at a pivot point 252. A portion 254 of the first lever element 250 is located above a protruding portion 215 of the floating unit 210. In this implementation, the protruding portion 215 is in contact with the portion 254 of the first lever element 250 under normal operation conditions. More specifically, the floating unit 210 abuts the portion 254 and exerts a force upwardly thereon on the first lever element 250 and therefore on a spring 218. A stiffness of the spring 218 is selected to counter the force of the floating unit 210 against the first lever element 250. In the event of a leak of the channelized liquid cooling into the water leaks into the oil, the floating unit 210 rises with the surface of the immersion cooling liquid 216, depressing the spring 218 via the lever assembly 270, as it will be described in greater details hereinafter. In the event of a leak of the immersion cooling liquid 216, the floating unit 210 drops with the surface of the immersion cooling liquid 216, thereby compressing the spring 218. In both cases, the leak detection systems 200 provides visual indication of the presence of a leak.

The second lever element 211 is attached to the protective housing 213 of the leak detection system 200, such as, for example, at a pivot point 216. In this implementation, the second lever 211 is maintained in position by the spring 218. In the "operating" configuration, the first lever element 250 may be distant from the second lever element 211. The second lever element 211 is also configured to be in contact with and retains the third lever element 212. The third lever element 212 is configured with a lever portion 212a containing an aperture 214. As described more fully below, under normal operations, the aperture 214 allows for an optical rack-mounted assembly locator beam 206 to travel there through. The optical rack-mounted assembly locator beam 206 originates from the optical transmitter 202 and travels to the optical receiver 204 where it is detected. Therefore, in normal operation, the first and second lever elements 211, 212 and the lever portion 212a of the second lever element 212 with the aperture 214 are oriented in a way that allows the optical rack-mounted assembly locator beam 206 to pass through the aperture 214.

Figure 3B shows the leak detection system 200 for under abnormal operations (i.e. "failure" configuration), in accordance with the implementations of the present disclosure. More specifically, Figure 3B shows the leak detection system 200 when the channelized cooling liquid leaks into the immersion cooling liquid. When said leak occurs in the immersion case 116, the floating unit 210 at a surface of the immersive cooling liquid rises and abuts against the first lever element 215. In this non-limitative example, the protruding portion 215 abuts a lower side of the portion 254. As the floating unit 210 continues to rise, the first lever element 250 rotates around the pivot point 252 (clockwise in the illustrative example of Figure 3B) and a portion 254 of the first lever element abuts against the second lever element 211 which in turn, rotates around the pivot point 216. By doing so, the second lever element 211 also compresses a spring 218 attached to the protective housing 213 of the leak detection system 200 and enables a translation of the third lever element 212 downwardly toward a final position. For example and without limitation, the second and third lever elements 211, 212 may define hook portions that are connected to one another in the operating configuration. Once the second lever element 212 rotates around the pivot point 216, the hook portions may detach or dislocate from one another such that the second lever element releases the third lever element 212.

In this implementation, when the second lever element 212 is released, the lever portion 212a of the second lever element 212 blocks the light beam 206. When the optical rack-mounted assembly locator beam 206 impinges the lever portion 212a, the interrupted light beam 206 warns an operator that there is an issue with the associated rack system 100 and indicates the exact location of the rack-mounted assembly 104 where a leak is occurring.

In some non-limiting implementations, the optical receiver 204 is connected to a controller (not shown). When the optical rack-mounted assembly locator beam 206 is detected by the optical receiver 204, the rack system 100 is functioning properly. However, when the optical rack-mounted assembly locator beam 206 is cut-off, the optical receiver 204 does not detect any light beam. In response to the absence of the light beam, the controller may transmit an alert signal to an operator device communicably connected thereto to indicate occurrence of an anomaly to an operator of the datacenter.

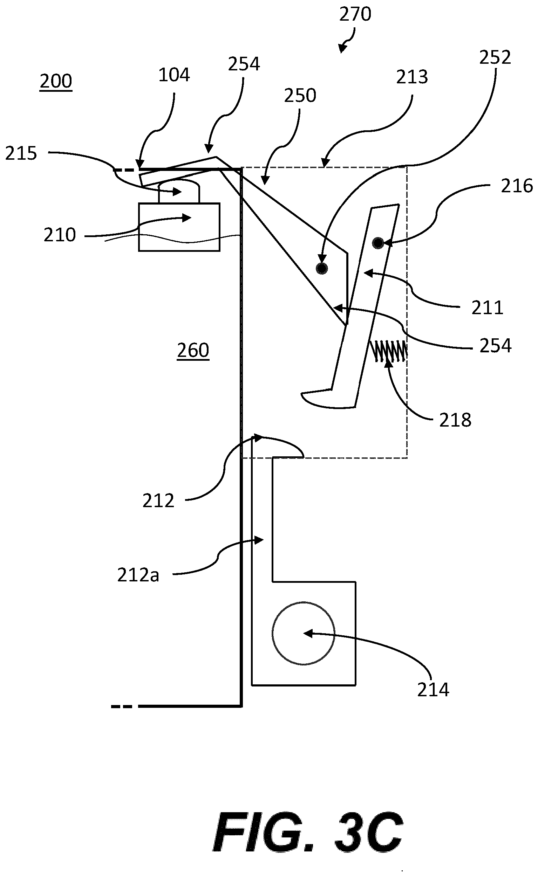

Figure 3C shows the leak detection system 200 for under abnormal operations (i.e. "failure" configuration), in accordance with the implementations of the present disclosure. More specifically, Figure 3C shows the leak detection system 200 when the immersion cooling liquid leaks out of the immersion casing 216. When said leak occurs, the floating unit 210 at a surface of the immersive cooling liquid drops and, given that the force of the spring 218 is equal to a force of the floating unit 210 against the first lever element 250 under normal operation conditions, the first lever element 250 rotates around the pivot point 252 (counter-clockwise in the illustrative example of Figure 3C) and the portion 254 of the first lever element abuts against the second lever element 211 which in turn, rotates around the pivot point 216. By doing so, the second lever element 211 also compresses a spring 218 attached to the protective housing 213 of the leak detection system 200 and enables a translation of the third lever element 212 downwardly toward the final position.

Therefore, it can be said that, in response to a variation of a level of the immersive cooling liquid being above a level threshold (i.e. that said level rises above a first level threshold or drops below a second level threshold), the floating unit 210 actuates the lever assembly 270 that in turn provides visual indication that a leak is occurring. In some implementations, an operator is required to manually reset the lever assembly 270. For example, the operator may push the third lever element 212 upwards. By doing so, the third lever element 212 will push the second lever element 211 that will, in turn, compress the spring 218. The second and third lever elements 211, 212 will thus interlock as shown on Figure 3A.

It is to be understood that the operations and functionality of the described datacenter leak detection system 200, its constituent components, and associated processes may be achieved by any one or more of hardware-based, software-based, and firmware-based elements. Such operational alternatives do not, in any way, limit the scope of the present disclosure.

It will be further understood that, although the implementations presented herein have been described with reference to specific features and structures, various modifications and combinations may be made without departing from the disclosure. For example, it is contemplated that in some implementations, two or more of the leak detection systems described above may be used, in any combination. The specification and drawings are, accordingly, to be regarded simply as an illustration of the discussed implementations or implementations and their principles as defined by the appended claims, and are contemplated to cover any and all modifications, variations, combinations or equivalents that fall within the scope of the present disclosure.

## Claims

1. A leak detection system (200) for a rack-mounted electronic processing assembly (104), the leak detection system (200) comprising:
a floating unit (210) positioned so as to be in contact with a surface of immersive cooling liquid contained in the rack-mounted assembly (104), the floating unit (210) including a protruding portion (215); and
a lever assembly (270) mounted on the rack-mounted assembly (104) and operatively coupled to the floating unit (210), the lever assembly (270) comprising:
a first lever element (250) having an upper portion (254) disposed above the protruding portion (215) of the floating unit (210) and lower portion coupled to a first pivot point (252);
a second lever element (211) having a surface disposed proximate to the lower portion of the first lever element (250), the second lever element (211) having an upper portion coupled to a second pivot point (216) and a lower portion;
a third lever element (212) having an upper portion that mechanically engages the lower portion of the second lever element (211) and a lower portion (212a) that incorporates an aperture (214) to enable an optical locator beam to pass therethrough;
wherein, in response to a variation of a level of the immersive cooling liquid being above a level threshold, the floating unit (210) actuates the lever assembly (270) to provide visual indication that a leak is occurring.

2. The leak detection system (200) of claim 1, wherein, in response to the floating unit (210) actuating the lever assembly, the actuation causes interruption of the optical locator beam (206) passage to indicate a location of the rack-mounted assembly (104).

3. The leak detection system (200) of claims 1 or 2, wherein the actuation causes a the second and third lever elements (211, 212) to dislocate from mechanical engagement.

4. The leak detection system (200) of any one of claims 1 to 3, wherein the lever assembly is mounted onto the top front face of the rack-mounted assemblies (104).

5. The leak detection system (200) of any one of claims 1 to 4, wherein the rack-mounted assembly (104) requires operator intervention to manually reset the lever assembly (270).

6. The leak detection system (200) of any one of claims 1 to 5, wherein the variation of a level of the immersive cooling liquid being above the level threshold is one of:
a surface of the immersive cooling liquid being above a first level threshold, or
a surface of the immersive cooling liquid being below a second level threshold.

7. A method for detecting presence of leaks in a datacenter rack-mounted electronic processing assembly (104) containing immersive cooling liquid (260), the method comprising:
positioning a floating unit (210) so as to be in contact with a surface of immersive cooling liquid contained in the rack-mounted assembly; and
mounting a lever assembly (270) on the rack-mounted assembly (104) to be operatively coupled to the floating unit (210), the lever assembly comprising:
a first lever element (250) having an upper portion (254) disposed above the protruding portion (215) of the floating unit (210) and lower portion coupled to a first pivot point (252);
a second lever element (211) having a surface disposed proximate to the lower portion of the first lever element (250), the second lever element (211) having an upper portion coupled to a second pivot point (216) and a lower portion;
a third lever element (212) having an upper portion that mechanically engages the lower portion of the second lever element (211) and a lower portion (212a) that incorporates an aperture (214) to enable an optical locator beam to pass therethrough;
wherein, in response to a variation of a level of the immersive cooling liquid being above a level threshold, the floating unit (210) actuates the lever assembly to provide visual indication that a leak is occurring.

8. The method of claim 7, further comprising indicating, to an operator of the datacenter, a location of the rack-mounted assembly (104) by a translation of a lever element (212) of the lever assembly in response to the floating unit (210) actuating the lever assembly.

9. The method of claims 7 or 8, wherein the lever portion (212a) obstructs the optical rack-mounted assembly locator beam (206) in response to the actuation of the lever assembly to indicate a location of the rack-mounted assembly (104).

10. The method of any one of claims 7 to 9, wherein the variation of a level of the immersive cooling liquid being above the level threshold is one of:
a surface of the immersive cooling liquid being above a first level threshold, or
a surface of the immersive cooling liquid being below a second level threshold.

## Patentansprüche

1. Leckerkennungssystem (200) für eine rackmontierte Baugruppe (104) zur elektronischen Verarbeitung, wobei das Leckerkennungssystem (200) umfasst:
eine schwimmende Einheit (210), die so positioniert ist, dass sie mit einer Oberfläche von Immersionskühlflüssigkeit, die in der rackmontierten Baugruppe (104) enthalten ist, in Kontakt ist, wobei die schwimmende Einheit (210) einen vorstehenden Abschnitt (215) einschließt; und
eine Hebelbaugruppe (270), die an der rackmontierten Baugruppe (104) montiert und betriebsmäßig mit der schwimmenden Einheit (210) gekoppelt ist, wobei die Hebelbaugruppe (270) umfasst:
ein erstes Hebelelement (250), das einen oberen Abschnitt (254), der oberhalb des vorstehenden Abschnitts (215) der schwimmenden Einheit (210) angeordnet ist, und einen unteren Abschnitt, der mit einem ersten Drehpunkt (252) gekoppelt ist, aufweist;
ein zweites Hebelelement (211), das eine Oberfläche aufweist, die in der Nähe des unteren Abschnitts des ersten Hebelelements (250) angeordnet ist, wobei das zweite Hebelelement (211) einen oberen Abschnitt, der mit einem zweiten Drehpunkt (216) gekoppelt ist, und einen unteren Abschnitt aufweist;
ein drittes Hebelelement (212), das einen oberen Abschnitt, der mechanisch mit dem unteren Abschnitt des zweiten Hebelelements (211) in Eingriff steht, und einen unteren Abschnitt (212a), der eine Öffnung (214) beinhaltet, um einem optischen Lokalisierungsstrahl zu ermöglichen, hindurchzutreten, aufweist;
wobei als Reaktion auf eine Variation eines Pegels der Immersionskühlflüssigkeit, die über einem Pegelschwellenwert liegt, die schwimmende Einheit (210) die Hebelbaugruppe (270) betätigt, um eine visuelle Anzeige bereitzustellen, dass ein Leck auftritt.

2. Leckerkennungssystem (200) nach Anspruch 1, wobei als Reaktion auf die schwimmende Einheit (210), die die Hebelbaugruppe betätigt, die Betätigung eine Unterbrechung des Durchgangs des optischen Lokalisierungsstrahls (206) verursacht, um einen Ort der rackmontierten Baugruppe (104) anzuzeigen.

3. Leckerkennungssystem (200) nach Anspruch 1 oder 2, wobei die Betätigung verursacht, dass sich das zweite und dritte Hebelelement (211, 212) vom mechanischen Eingriff lösen.

4. Leckerkennungssystem (200) nach einem der Ansprüche 1 bis 3, wobei die Hebelbaugruppe an der oberen Vorderseite der rackmontierten Baugruppen (104) montiert ist.

5. Leckerkennungssystem (200) nach einem der Ansprüche 1 bis 4, wobei die rackmontierte Baugruppe (104) einen Bedienereingriff erfordert, um die Hebelbaugruppe (270) manuell zurückzusetzen.

6. Leckerkennungssystem (200) nach einem der Ansprüche 1 bis 5, wobei die Variation eines Pegels der Immersionskühlflüssigkeit, die über dem Pegelschwellenwert liegt, eines von Folgendem ist:
eine Oberfläche der Immersionskühlflüssigkeit, die über einem ersten Pegelschwellenwert liegt, oder
eine Oberfläche der Immersionskühlflüssigkeit, die unter einem zweiten Pegelschwellenwert liegt.

7. Verfahren zum Erkennen des Vorhandenseins von Lecks in einer rackmontierten Baugruppe (104) zur elektronischen Verarbeitung eines Rechenzentrums, die Immersionskühlflüssigkeit (260) enthält, wobei das Verfahren umfasst:
Positionieren einer schwimmenden Einheit (210), so dass sie mit einer Oberfläche von Immersionskühlflüssigkeit, die in der rackmontierten Baugruppe enthalten ist, in Kontakt ist; und
Montieren einer Hebelbaugruppe (270) an der rackmontierten Baugruppe (104), um betriebsmäßig mit der schwimmenden Einheit (210) gekoppelt zu sein, wobei die Hebelbaugruppe umfasst:
ein erstes Hebelelement (250), das einen oberen Abschnitt (254), der oberhalb des vorstehenden Abschnitts (215) der schwimmenden Einheit (210) angeordnet ist, und einen unteren Abschnitt, der mit einem ersten Drehpunkt (252) gekoppelt ist, aufweist;
ein zweites Hebelelement (211), das eine Oberfläche aufweist, die in der Nähe des unteren Abschnitts des ersten Hebelelements (250) angeordnet ist, wobei das zweite Hebelelement (211) einen oberen Abschnitt, der mit einem zweiten Drehpunkt (216) gekoppelt ist, und einen unteren Abschnitt aufweist;
ein drittes Hebelelement (212), das einen oberen Abschnitt, der mechanisch mit dem unteren Abschnitt des zweiten Hebelelements (211) in Eingriff steht, und einen unteren Abschnitt (212a), der eine Öffnung (214) beinhaltet, um einem optischen Lokalisierungsstrahl zu ermöglichen, hindurchzutreten, aufweist;
wobei als Reaktion auf eine Variation eines Pegels der Immersionskühlflüssigkeit, die über einem Pegelschwellenwert liegt, die schwimmende Einheit (210) die Hebelbaugruppe betätigt, um eine visuelle Anzeige bereitzustellen, dass ein Leck auftritt.

8. Verfahren nach Anspruch 7, ferner umfassend das Anzeigen eines Orts der rackmontierten Baugruppe (104) an einen Bediener des Rechenzentrums durch eine Translation eines Hebelelements (212) der Hebelbaugruppe als Reaktion auf die schwimmende Einheit (210), die die Hebelbaugruppe betätigt.

9. Verfahren nach Anspruch 7 oder 8, wobei der Hebelabschnitt (212a) den optischen Lokalisierungsstrahl (206) der rackmontierten Baugruppe als Reaktion auf die Betätigung der Hebelbaugruppe blockiert, um einen Ort der rackmontierten Baugruppe (104) anzuzeigen.

10. Verfahren nach einem der Ansprüche 7 bis 9, wobei die Variation eines Pegels der Immersionskühlflüssigkeit, die über dem Pegelschwellenwert liegt, eines von Folgendem ist:
eine Oberfläche der Immersionskühlflüssigkeit, die über einem ersten Pegelschwellenwert liegt, oder
eine Oberfläche der Immersionskühlflüssigkeit, die unter einem zweiten Pegelschwellenwert liegt.

## Revendications

1. Système de détection de fuite (200) pour un ensemble de traitement électronique monté sur bâti (104), le système de détection de fuite (200) comprenant :
une unité flottante (210) positionnée de manière à être en contact avec une surface de liquide de refroidissement par immersion contenu dans l'ensemble monté sur bâti (104), l'unité flottante (210) comportant une partie saillante (215) ; et
un ensemble levier (270) monté sur l'ensemble monté sur bâti (104) et couplé de manière opérationnelle à l'unité flottante (210), l'ensemble levier (270) comprenant :
un premier élément de levier (250) ayant une partie supérieure (254) disposée au-dessus de la partie saillante (215) de l'unité flottante (210) et une partie inférieure couplée à un premier point de pivot (252) ;
un deuxième élément de levier (211) ayant une surface disposée à proximité de la partie inférieure du premier élément de levier (250), le deuxième élément de levier (211) ayant une partie supérieure couplée à un second point de pivot (216) et une partie inférieure ;
un troisième élément de levier (212) ayant une partie supérieure qui vient mécaniquement en prise avec la partie inférieure du deuxième élément de levier (211) et une partie inférieure (212a) qui incorpore une ouverture (214) pour permettre le passage d'un faisceau de localisation optique à travers celle-ci ;
dans lequel, en réponse à une variation d'un niveau du liquide de refroidissement par immersion au-dessus d'un seuil de niveau, l'unité flottante (210) actionne l'ensemble levier (270) pour fournir une indication visuelle de survenue d'une fuite.

2. Système de détection de fuite (200) selon la revendication 1, dans lequel, en réponse à l'actionnement de l'ensemble levier par l'unité flottante (210), l'actionnement provoque l'interruption du passage du faisceau de localisation optique (206) pour indiquer l'emplacement de l'ensemble monté sur bâti (104).

3. Système de détection de fuite (200) selon les revendications 1 ou 2, dans lequel l'actionnement provoque la libération de la mise en prise mécanique des deuxième et troisième éléments de levier (211, 212).

4. Système de détection de fuite (200) selon l'une quelconque des revendications 1 à 3, dans lequel l'ensemble levier est monté sur la face avant supérieure des ensembles montés sur bâti (104).

5. Système de détection de fuite (200) de l'une quelconque des revendications 1 à 4, dans lequel l'ensemble monté sur bâti (104) nécessite l'intervention de l'opérateur pour réinitialiser manuellement l'ensemble levier (270).

6. Système de détection de fuite (200) selon l'une quelconque des revendications 1 à 5, dans lequel la variation d'un niveau du liquide de refroidissement par immersion au-dessus du seuil de niveau est l'une des suivantes :
une surface du liquide de refroidissement par immersion se trouvant au-dessus d'un premier seuil de niveau, ou
une surface du liquide de refroidissement par immersion se trouvant en dessous d'un second seuil de niveau.

7. Procédé de détection de la présence de fuites dans un ensemble de traitement électronique monté sur bâti (104) pour centre de données contenant un liquide de refroidissement par immersion (260), le procédé comprenant :
le positionnement d'une unité flottante (210) de manière à être en contact avec une surface de liquide de refroidissement par immersion contenu dans l'ensemble monté sur bâti ; et
le montage d'un ensemble levier (270) sur l'ensemble monté sur bâti (104) pour être couplé de manière opérationnelle à l'unité flottante (210), l'ensemble levier comprenant :
un premier élément de levier (250) ayant une partie supérieure (254) disposée au-dessus de la partie saillante (215) de l'unité flottante (210) et une partie inférieure couplée à un premier point de pivot (252) ;
un deuxième élément de levier (211) ayant une surface disposée à proximité de la partie inférieure du premier élément de levier (250), le deuxième élément de levier (211) ayant une partie supérieure couplée à un second point de pivot (216) et une partie inférieure ;
un troisième élément de levier (212) ayant une partie supérieure qui vient mécaniquement en prise avec la partie inférieure du deuxième élément de levier (211) et une partie inférieure (212a) qui incorpore une ouverture (214) pour permettre le passage d'un faisceau de localisation optique à travers celle-ci ;
dans lequel, en réponse à une variation d'un niveau du liquide de refroidissement par immersion au-dessus d'un seuil de niveau, l'unité flottante (210) actionne l'ensemble levier pour fournir une indication visuelle de survenue d'une fuite.

8. Procédé selon la revendication 7, comprenant également l'indication, à un opérateur du centre de données, d'un emplacement de l'ensemble monté sur bâti (104) par une translation d'un élément de levier (212) de l'ensemble levier en réponse à l'actionnement de l'ensemble de lever par l'unité flottante (210).

9. Procédé selon les revendications 7 ou 8, dans lequel la partie de levier (212a) obstrue le faisceau de localisation de l'ensemble monté sur bâti optique (206) en réponse à l'actionnement de l'ensemble levier pour indiquer un emplacement de l'ensemble monté sur bâti (104).

10. Procédé selon l'une quelconque des revendications 7 à 9, dans lequel la variation d'un niveau du liquide de refroidissement par immersion au-dessus du seuil de niveau est l'une des suivantes :
une surface du liquide de refroidissement par immersion se trouvant au-dessus d'un premier seuil de niveau, ou
une surface du liquide de refroidissement par immersion se trouvant en dessous d'un second seuil de niveau.
